# FASCICULE DE BREVET EUROPEEN

(11) **EP 0 368 733 B1**
(45) Date de publication et mention de la délivrance du brevet: **15.09.1993**
(21) Numéro de dépôt: 89403041.0
(22) Date de dépôt: 06.11.1989
(51) Int. Cl.: G02F 1/136, H01L 21/84, H01L 29/78

(54) **Procédé de fabrication d'un écran d'affichage à matrice de transistors pourvus d'un masque optique**
Herstellungsprozess für einen Anzeigebildschirm mit einer Transistormatrix, versehen mit einer lichtundurchlässigen Maske
Manufacturing process for a display device incorporating a transistor matrix array provided with a light shielding mask

(30) Priorité: 08.11.1988 FR 8814562
(43) Date de publication de la demande: 16.05.1990
(73) Titulaire: FRANCE TELECOM, 75015 Paris (FR)
(72) Inventeur: Vinouze, Bruno, F-22710 Port-Blanc (FR); Lebrun, Hugues, F-22660 Trevou-Treguignec (FR)
(74) Mandataire: Mongrédien, André

(56) Documents cités:
- EP-A- 0 179 915
- EP-A- 0 231 953
- EP-A- 0 267 825
- EP-A- 0 271 313
- PROCEEDINGS OF THE SOCIETY FOR INFORMATION DISPLAY, vol. 27, no. 3, 1986, pp 229-234, New York, USA; T. SUNATA et al.: "A Large-Area High-Resolution Active-Matrix Color LCD Addressed by a-Si TFT's".
- IBM TECHNICAL DISCLOSURE BULLETIN, vol. 29, no. 12, mai 1987, pp 5463,5464, Armonk, New York, USA; "Semiconductor integrated display".
- PATENT ABSTRACTS OF JAPAN, vol. 7, no. 286 (P-244)(1431), 21 décembre 1983; & JP A 58159520.
- PATENT ABSTRACTS OF JAPAN, vol. 11, no. 212 (E-522)(2659), 9 juillet 1987; & JP A 62033471.
- PATENT ABSTRACTS OF JAPAN, vol. 11, no. 355 (E-558)(2802), 19 novembre 1987; & JP A 62132367.
- PATENT ABSTRACTS OF JAPAN, vol. 10, no. 7 (P-419)(2064), 11 janvier 1986; & JP A 60164723.

## Description

La présente invention a pour objet un procédé de fabrication d'un écran d'affichage à matrice active, à base de transistors en couches minces et de condensateurs, dans laquelle les transistors sont pourvus d'un masque optique. Elle trouve une application notamment dans la réalisation de circuits d'affichage à cristaux liquides.

Les circuits à transistors en couches minces (T.C.M.) sont principalement utilisés dans la fabrication d'écrans d'affichage à matrice active. Dans ce type d'écran, une mémoire électronique formée de points mémoire répartis sur toute la surface de l'écran, stocke le signal vidéo pendant toute la durée de l'image. Le transducteur électrooptique (par exemple un cristal liquide) est en contact avec chaque point mémoire, et est excité pendant toute la durée d'une image, alors que, dans les systèmes dépourvus de mémoire électronique, le transducteur n'est excité que pendant la durée d'une ligne. L'effet optique et le taux de multiplexage autorisé sont donc beaucoup plus importants.

Les TCM permettent de réaliser une telle mémoire électronique sur un substrat de verre. Chaque point mémoire est situé au croisement d'une ligne et d'une colonne de connexion et il est constitué de deux transistors en parallèle et d'un condensateur. Dans le cas où le transducteur est un cristal liquide, les armatures du condensateur peuvent être constituées par les électrodes de la cellule à cristal liquide elle-même. Le point mémoire se ramène donc à deux TCM et à un condensateur dont l'une des armatures est constituée par l'électrode disposée sur la paroi de la cellule qui contient les TCM, l'autre armature étant constituée par la contre-électrode disposée sur l'autre paroi de la cellule.

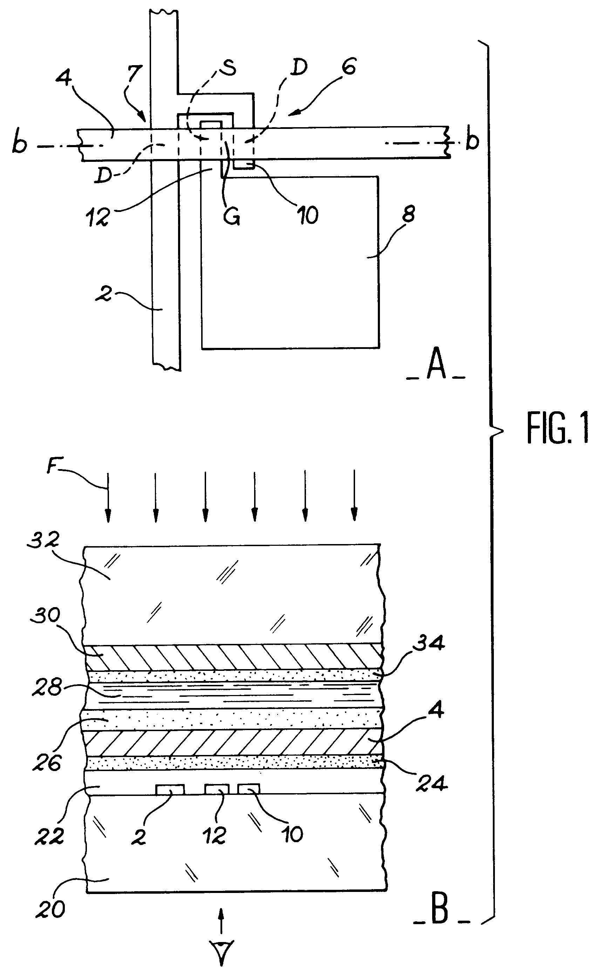

Une telle structure est représentée sur la figure 1 ; la partie A est une vue de dessus d'un point de la matrice active et la partie B est une vue en coupe selon la ligne b-b de la partie A.

Sur la partie A, on voit une colonne conductrice 2 et une ligne conductrice 4 constituant les colonnes et les lignes d'adressage des points de la matrice active, deux TCM 6 et 7 en parallèle et une électrode transparente 8 constituant l'une des armatures des condensateurs ou points élémentaires d'affichage de la matrice active.

Chaque colonne 2 est pourvue d'une crosse 10 et chaque électrode 8 d'un doigt 12. Les croisements de la ligne 4 avec la colonne 2 et la crosse 10 définissent les drains D des TCM et le croisement de la ligne 4 avec le doigt 12 définit la source S des TCM. La partie de la ligne 4 située entre la colonne 2 et la crosse 10 constituent la grille G des TCM.

Sur la partie B, on voit d'une part une paroi inférieure 20 isolante et transparente, portant la colonne 2, le doigt 12 du point élémentaire d'affichage et la crosse 10 ; ces éléments conducteurs 2, 10 et 12 sont recouverts d'une couche 22 de silicium amorphe hydrogéné, puis d'une couche 24 d'isolant de grille supportant les lignes conductrices 4. Cet ensemble est recouvert d'une couche d'alignement 26 destinée à être au contact du matériau électro-optique 28 (cristal liquide).

En outre, l'écran d'affichage comprend une contre-électrode 30 transparente supportée par une paroi supérieure 32 isolante et transparente.

Dans le cadre d'un affichage en couleur, des filtres colorés 34, généralement au nombre de trois (rouges, bleus et verts), doivent être prévus sur la contre-électrode 30 et au contact du matériau 28.

A côté des matrices actives, d'autres circuits peuvent être réalisés avec des TCM et par exemple tout ou partie des registres à décalage.

Cet écran est destiné à être éclairé par l'arrière avec des tubes fluorescents et l'affichage est destiné à être observé par la face inférieure, comme représenté sur la partie B de la figure 1. Le métal de grille, c'est-à-dire celui constituant les lignes 4, assure une protection des TCM 6 contre la lumière arrière de l'écran d'affichage. En revanche, le "ventre" des TCM se trouve exposé à la lumière ambiante d'observation. Si cette lumière est intense, un photo-courant est engendré dans la couche 24 de silicium amorphe diminuant le contraste de l'écran, car le rapport Ion/Ioff diminue ; Ion et Ioff représentent respectivement les courants délivrés par les transistors d'un point affiché et d'un point non affiché.

En utilisant une épaisseur faible de silicium amorphe (< 50 nm), ce photo-courant est atténué mais reste suffisant pour diminuer le contraste. Aussi, un masque optique sous les transistors doit être prévu pour servir d'écran à la lumière ambiante et assurer ainsi un rendu d'image constant.

Pour faire un masque optique absorbant la lumière sous les TCM, on utilise généralement un métal que l'on grave. Le masque optique étant conducteur, une couche de passivation est nécessaire. Une telle structure est décrite dans l'article Japan Display 1983, p.211 de Canon.

Cette technique nécessite deux dépôts sous vide, ce qui est relativement contraignant, ainsi qu'un niveau de masquage spécifique pour définir la forme et l'emplacement du masque optique sous les transistors. Ce niveau de masquage supplémentaire exige une grande précision d'alignement de ce masque par rapport au contact sources et drains des transistors. Cette technique est donc relativement complexe et délicate.

L'invention a justement pour but d'éviter ces inconvénients en assurant un masquage optique du "ventre" des transistors d'une matrice active tout en réduisant le nombre de niveaux de masquage et en assurant un auto-positionnement de ces masques optiques par rapport aux sources et aux drains des transistors.

L'invention a donc pour objet un procédé de fabrication d'un écran d'affichage à matrice active formée de points constitués chacun d'un transistor en couches minces et d'un condensateur et comportant des lignes et des colonnes conductrices pour l'adressage des points, consistant à :
a) déposer sur un substrat électriquement isolant une couche d'un premier matériau électriquement isolant, absorbant la lumière visible et soluble dans le révélateur d'une résine photosensible positive,
b) déposer sur la couche absorbante une couche de ladite résine,
c) insoler la résine à travers un masque négatif masquant les canaux des transistors à réaliser,
d) éliminer les zones insolées de la résine et les zones sous-jacentes de la couche absorbante avec ledit révélateur,
e) déposer une couche d'un premier matériau conducteur transparent sur l'ensemble,
f) éliminer le restant de résine et le premier matériau conducteur recouvrant ladite résine pour former les sources et drains des transistors dans le premier matériau conducteur,
g) déposer une couche de silicium amorphe hydrogéné sur l'ensemble,
h) déposer une couche d'un second matériau isolant électrique sur la couche de silicium,
i) déposer une couche d'un second matériau conducteur sur la couche de second matériau isolant,
j) photograver l'empilement formé des couches de second matériau conducteur, de second matériau isolant et de silicium pour former la grille des transistors de façon que la couche de silicium est au contact de la source et du drain des transistors, et
k) passiver l'ensemble en déposant une couche d'un troisième matériau électriquement isolant.

Le procédé selon l'invention ne comporte aucune étape critique et uniquement deux niveaux de masquage. Il permet la suppresion du photo-courant des transistors en couches minces dû à l'éclairage ambiant de l'écran d'affichage.

Le procédé selon l'invention permet en outre d'utiliser une couche de silicium amorphe relativement épaisse (> 200 nm), ce qui donne un meilleur matériau et surtout un contrôle de son épaisseur moins critique.

En outre, le canal des transistors est posé sur un plot de matériau isolant électriquement et absorbant qui sert également de matériau de passivation. Ceci est particulièrement intéressant lorsque le substrat isolant est du verre. En effet, il n'y a plus risque de pollution du silicium amorphe par les ions contenus dans le verre du substrat. Ainsi un verre bon marché peut être utilisé, tel qu'un verre sodo-calcique, réduisant ainsi le coût de l'écran d'affichage.

Avantageusement, le matériau absorbant est une résine polymérisable renfermant les colorants opaques, la polymérisation de cette résine étant effectuée en particulier juste avant le dépôt de la couche de silicium amorphe hydrogéné.

L'invention a également pour objet un écran d'affichage à matrice active obtenu par le procédé décrit précédemment. Selon l'invention, cette matrice est formée sur un substrat isolant électrique et comporte des points, des lignes et des colonnes conductrices pour l'adressage des points, chaque point étant constitué d'un condensateur et d'un transistor en couches minces comprenant essentiellement un masque optique en matériau électriquement isolant, absorbant la lumière visible situé sous le canal du transistor et directement sur le substrat, une source et un drain autopositionnés par rapport au masque optique et au contact direct du substrat, ainsi qu'une grille surmontant le masque optique et séparée de ce dernier par du silicium amorphe hydrogéné et un matériau électriquement isolant empilés, le silicium amorphe étant au contact de la source et du drain.

La technique de fabrication des sources et drains dans le procédé conforme à l'invention, connue sous le nom de "lift-off" ou pelage assure un auto-positionnement des sources et drains des transistors par rapport au masque optique de ces derniers. En outre, si l'épaisseur du matériau absorbant et du premier matériau conducteur dans lequel sont définis les sources et drains des transistors est judicieusement choisie, on obtient une structure sous le silicium amorphe hydrogéné plane, c'est-à-dire une structure exempte de marche. Or, on sait que les passages de marches peuvent être sources de défauts dans les transistors et aux environnements des lignes et colonnes d'adressage.

D'autres caractéristiques et avantages de l'invention ressortiront mieux de la description qui va suivre donnée à titre explicatif et nullement limitatif en référence aux figures 2 à 4 annexées, la figure 1 ayant déjà été décrite.
- la figure 2 représente, en coupe, les diverses étapes du procédé selon l'invention appliqué à la fabrication d'un écran d'affichage à cristal liquide,
- la figure 3 représente, en vue de dessus, la face avant d'un écran d'affichage obtenu par le procédé selon l'invention,
- la figure 4 représente, en vue de dessus, la face avant d'un écran d'affichage obtenu par les procédés selon l'art antérieur.

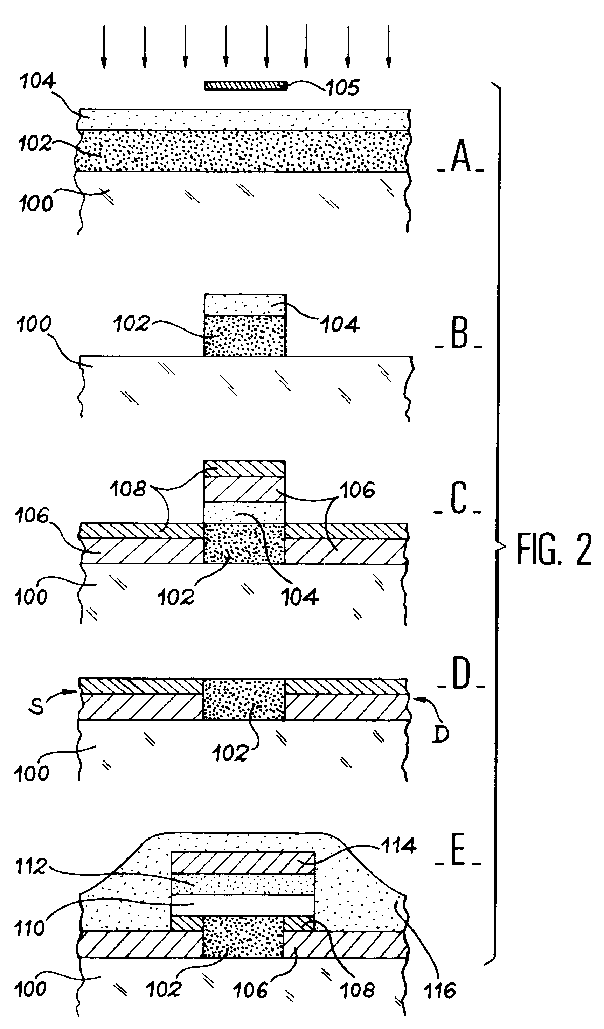

Afin de simplifier la description relative à la fabrication selon l'invention d'un écran d'affichage, en référence à la figure 2, celle-ci est uniquement faite pour la fabrication d'un transistor en couches minces d'un point d'une matrice active de cet écran d'affichage.

La première étape de fabrication d'un transistor en couches minces, masqué optiquement, consiste, comme représenté sur la partie A de la figure 2, à déposer sur un substrat en verre 100 du type sodo-calcique, à la tournette, une couche de polyimide 102 renfermant des colorants de la famille des anthraquinones, des azoïques et des phtalocyanines afin de rendre opaque cette couche de polyimide, puis à prépolymériser celle-ci à 150°C pendant 30 minutes. Le polyimide est en particulier celui commercialisé par BREWER SCIENCE, P.O. Box GG ROLLA, MO65401, USA.

On dépose ensuite sur la couche 102 de polyimide noir, une couche de résine photosensible positive (par exemple du type 1350H de SHIPLEY) que l'on sèche à 100°C pendant 30 minutes. Cette résine est alors insolée à travers un masque négatif 105 assurant le masquage du canal du transistor à réaliser, cette insolation étant effectuée avec des ultra-violets. Ensuite, on révèle la résine exposée ; cette révélation a pour effet d'éliminer la résine exposée et de solubiliser le polyimide non protégé par la résine exposée. La structure obtenue est celle représentée sur la partie B. On a ainsi délimité le futur canal du transistor. Le révélateur utilisé est par exemple MF 312 de SHIPLEY.

Le masque de résine 104 toujours en place, on vient déposer par évaporation une couche 106 conductrice transparente, par exemple en oxyde d'étain et d'indium (ITO) et éventuellement une couche de métal 108, par exemple en chrome, de façon à obtenir ultérieurement le niveau 1 de la structure (figure D) plane. A cet effet, l'épaisseur totale des couches 106 et 108 doit être égale à l'épaisseur de la couche de polyimide 102. Par exemple, la couche 102 peut avoir une épaisseur de 1000 nm, la couche 106 une épaisseur de 700 nm et la couche 108 une épaisseur de 300 nm.

Les dépôts des couches 106 et 108 sont effectués sur l'ensemble de la structure, c'est-à-dire sur les parties du substrat 100 exposées ainsi que sur la résine 104 restante.

On dissout alors la résine 104 dans du Stripper de chez BREWER SCIENCE éliminant ainsi les métaux 106 et 108 déposés sur la résine. On obtient ainsi les contacts sources et drains respectivement S et D du transistor en couches minces et le canal du transistor est mis à nu, comme représenté sur la partie D de la figure 2. On effectue alors un recuit éventuellement sous vide jusqu'à une température de 400°C environ afin de polymériser la totalité du polyimide noir 102 restant, sans perte importante de l'absorbance de ce matériau.

La fabrication du transistor se poursuit, comme représenté sur la partie E de la figure 2, par dépôt d'une couche de silicium amorphe hydrogéné 110, d'une couche de nitrure de silicium 112 et enfin d'une couche d'aluminium 114, sur l'ensemble de la structure. Les couches 110 et 112 sont obtenues par dépôt chimique en phase vapeur assisté plasma (PECVD), l'aluminium 114 est déposé par évaporation ou pulvérisation. On effectue alors une photogravure de l'empilement des couches 114, 112, 110 et 108 de façon connue, pour définir la grille du transistor.

La dernière étape du procédé consiste à passiver l'ensemble de la structure par dépôt d'une couche 116 de nitrure de silicium.

Le procédé décrit en référence à la figure 2, est compatible avec le procédé de fabrication d'un écran d'affichage à matrice active décrit dans le document EP-A-0-103-523 et dans le document FR-A-2 571 893.

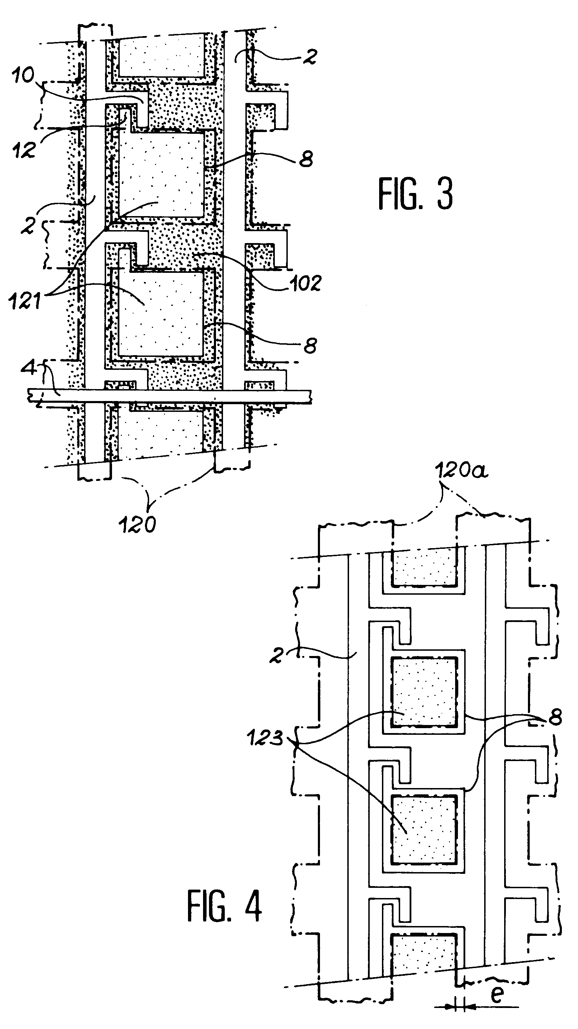

M Lors de la fabrication d'un écran d'affichage complet, le masque négatif 105 servant au masquage du canal des transistors sert aussi à masquer l'une des armatures des condensateurs ainsi que les colonnes conductrices de l'écran d'affichage à réaliser. Ces armatures 8 et ces colonnes 2 (figures 1, 3) sont alors formées en même temps que les contacts sources et drains des transistors par la technique du "lift-off". En outre, les lignes d'adressage 4 de l'écran d'affichage sont formées simultanément à la grille du transistor, dans la couche conductrice 114.

A cet effet, on a représenté une vue de dessus de la face avant d'une partie d'un écran d'affichage obtenu par le procédé selon l'invention, sur la figure 3. On retrouve sur cette figure 3, les colonnes d'adressage 2, les électrodes transparentes 8 en ITO, les crosses 10 solidaires des colonnes 2 et les doigts 12 des points d'affichage solidaires des électrodes 8.

Le procédé selon l'invention permet de recouvrir toutes les zones entourant les électrodes 8 et les colonnes 2 équipées respectivement de leur crosse 10 et de leurs doigts 12, de polyimide noir 102. Il est alors possible de déposer un masque optique symbolisé en traits mixtes sur la figure 3 et portant la référence 120, sur la contre-électrode 30 (figure 1) légèrement plus large que les colonnes 2, et ce, sans alignement critique de la contre-électrode 30 par rapport à la matrice active, afin que seuls les points élémentaires d'affichage 8 transmettent la lumière.

Le taux d'ouverture de l'écran d'affichage, correspondant au pourcentage de transmission de la lumière, est le rapport de la surface réellement utile à l'affichage sur la surface totale de l'écran. La surface utile 121, grâce au procédé de l'invention est égale à la surface des électrodes 8. Dans ce cas, le taux d'ouverture est de 71 %.

Dans le cas classique, représenté sur la figure 1, il n'y a pas de polyimide noir autour des points élémentaires d'affichage. Aussi, est-il nécessaire de prévoir sur la contre-électrode 30 un masque optique 120a, symbolisé en traits mixtes, plus large que les colonnes 2, comme représenté sur la figure 4, venant même recouvrir d'une épaisseur e de l'ordre de 10 microns les électrodes 8 et donc les points élémentaires d'affichage, du fait des tolérances d'alignement entre la contre-électrode et la marice active. Ce recouvrement e diminue alors la surface utile 123 du point élémentaire d'affichage. Le taux d'ouverture de l'écran est dans ce cas de 63 %.

## Revendications

1. Procédé de fabrication d'un écran d'affichage à matrice active formée de points constitués chacun d'un transistor (6) en couches minces et d'un condensateur (8) et comportant des lignes (4) et des colonnes (2) conductrices pour l'adressage des points, consistant à :
a) déposer sur un substrat électriquement isolant (100) une couche d'un premier matériau électriquement isolant (102), absorbant la lumière visible et soluble dans le révélateur d'une résine photosensible positive,
b) déposer sur la couche absorbante une couche (104) de ladite résine,
c) insoler la résine à travers un masque négatif (105) masquant les canaux des transistors à réaliser,
d) éliminer les zones insolées de la résine et les zones sous-jacentes de la couche absorbante avec ledit révélateur,
e) déposer une couche d'un premier matériau conducteur (106) transparent sur l'ensemble,
f) éliminer le restant de résine et le premier matériau conducteur recouvrant ladite résine pour former les sources (S) et drains (D) des transistors (6) dans le premier matériau conducteur,
g) déposer une couche de silicium amorphe hydrogéné (110) sur l'ensemble,
h) déposer une couche d'un second matériau isolant électrique (112) sur la couche de silicium,
i) déposer une couche d'un second matériau conducteur (114) sur la couche de second matériau isolant,
j) photograver l'empilement formé des couches (114, 112, 110) de second matériau conducteur, de second matériau isolant et de silicium pour former la grille
(G) des transistors de façon que la couche de silicium (110) est au contact de la source (S) et du drain (D) des transistors, et
k) passiver l'ensemble en déposant une couche d'un troisième matériau électriquement isolant (116).

2. Procédé selon la revendication 1, caractérisé en ce que le matériau absorbant (104) est une résine polymérisable renfermant des colorants opaques.

3. Procédé selon la revendication 2, caractérisé en ce que l'on effectue un recuit de l'ensemble, entre les étapes f et g pour polymériser la résine.

4. Procédé selon la revendication 2 ou 3, caractérisé en ce que la résine polymérisable est un polyimide.

5. Procédé selon l'une quelconque des revendications 1 à 4, caractérisé en ce que l'on dépose une couche d'un troisième matériau conducteur (108), entre les étapes e et f, dont l'épaisseur est telle que l'épaisseur de l'ensemble des premier et troisième matériaux conducteurs (106, 108) soit égale à l'épaisseur de matériau absorbant (104).

6. Procédé selon l'une quelconque des revendications 1 à 5, caractérisé en ce que le masque négatif (105) sert aussi à masquer l'une des armatures (8) des condensateurs à réaliser ainsi que les colonnes (2) à réaliser et en ce que l'on forme ces armatures et ces colonnes au cours de l'étape f.

7. Procédé selon la revendication 6, caractéri sé en ce que l'on forme aussi les lignes (4) au cours de l'étape j.

8. Ecran d'affichage à matrice active formée sur un substrat isolant électrique (100) et comportant des points, des lignes (4) et des colonnes (6) conductrices pour l'adressage des points, chaque point étant constitué d'un condensateur (8) et d'un transistor (6) en couches minces caracterisé en ce qu'il comprend un masque optique (102) en matériau électriquement isolant, absorbant la lumière visible, situé sous le canal du transistor et directement sur le substrat, une source (S) et un drain (D) autopositionnés par rapport au masque optique et au contact direct du substrat, ainsi qu'une grille (114) surmontant le masque optique et séparée de ce dernier par du silicium amorphe hydrogéné (110) et un matériau électriquement isolant (112) empilés, le silicium amorphe étant au contact de la source et du drain.

## Claims

1. Process for the production of an active matrix display screen formed from points, each of which is constituted by a thin film transistor (6) and a capacitor (8) and having conductive columns (2) and rows (4) for addressing the points and comprising:
a) depositing on an electrically insulating substrate (100) a layer of a first electrically insulating material (102) absorbing the visible light and soluble in the developer of a positive photosensitive resin,
b) depositing on the absorbing layer a layer (104) of said resin,
c) irradiating the resin through a negative mask (105) masking the channels of the transistors to be produced,
d) eliminating the irradiated areas of the resin and the underlying areas of the absorbing layer with said developer,
e) depositing a layer of a first transparent, conductive material (106) on the assembly,
f) eliminating the remainder of the resin and the first conductive material covering said resin in order to form the sources (S) and drains (D) of the transistors (6) in the first conductive material,
g) depositing an amorphous hydrogenated silicon layer (110) on the assembly,
h) depositing a layer of a second electrically insulating material (112) on the silicon layer,
i) depositing a layer of a second conductive material (114) on the second insulating material layer,
j) photoengraving the stack formed by the layers (114, 112, 110) of the second conductive material, the second insulating material and the silicon in order to form the gate (G) of the transistors, so that the silicon layer (110) is in contact with the source (S) and drain (D) of the transistors and
k) passivating the assembly by depositing a layer of a third electrically insulating material (116).

2. Process according to claim 1, characterized in that the absorbent material (104) is a polymerizable resin containing opaque dyes.

3. Process according to claim 2, characterized in that the assembly is annealed between stages f and g in order to polymerize the resin.

4. Process according to claim 2 or 3, characterized in that the polymerizable resin is a polyimide.

5. Process according to any one of the claims 1 to 4, characterized in that deposition takes place of a layer of a third conductive material (108), between stages e and f and its thickness is such that the thickness of the assembly formed by the first and third conductive materials (106, 108) is equal to the thickness of the absorbent material (104).

6. Process according to any one of the claims 1 to 5, characterized in that the negative mask (105) is also used for masking one of the coatings (8) of the capacitors to be produced, as well as the columns (2) to be produced and in that the said coatings and columns are produced during stage f.

7. Process according to claim 6, characterized in that the rows (4) are also formed during stage j.

8. Active matrix display screen formed on an electrically insulating substrate (100) and having points, conductive rows (4) and columns (6) for addressing the points, each point being constituted by a capacitor (8) and a thin film transistor (6), characterized in that it comprises an optical mask (102) made from an electrically insulating material and which absorbs the visible light located beneath the transistor channel and directly on the substrate, a source (S) and a drain (D) self-aligned with respect to the optical mask and in direct contact with the substrate, as well as a gate (114) surmounting the optical mask and separated from the latter by amorphous hydrogenated silicon (110) and an electrically insulating material (112) in stacked form, the amorphous silicon being in contact with the source and the drain.

## Patentansprüche

1. Verfahren zur Herstellung eines Anzelgeschirms mit Aktivmatrix, gebildet aus Punkten, die je aus einem Dünnschichttransistor (6) und einem Kondensator (8) bestehen, und umfassend Leitungszeilen (4) und -spalten (2), um die Punkte zu adressieren, umfassend:
a) Aufbringen einer Schicht (102) eines ersten elektrisch isolierenden Materials, welches sichtbares Licht absorbiert und im Entwickler eines positiv photoempfindlichen Harz löslich ist, auf ein elektrisch isolierendes Substrat (100),
b) Aufbringen einer Schicht (104) dieses Harzes auf die absorbierende Schicht,
c) Belichten des Harzes über eine Negativmaske (105), die die Kanäle der herzustellenden Transistoren abdeckt,
d) Entfernen der belichteten Bereiche des Harzes und der darunterliegenden Bereiche der absorbierenden Schicht mit dem Entwickler,
e) Aufbringen einer Schicht eines ersten transparenten Leitungsmaterials (106) auf das Bauteil,
f) Entfernen der Harzreste und des ersten Leitungsmaterials, welches das Harz bedeckt, um die Sources (S) und Drains (D) der Transistoren (6) im ersten Leitungsmaterial zu bilden,
g) Auftragen einer Schicht (110) aus hydrierten, amorphen Silizium auf das Bauteil,
h) Auftragen einer Schicht eines zweiten, elektrisch isolierenden Materials (112) auf die Siliziumschicht,
i) Auftragen einer Schicht eines zweiten Leitungsmaterials (114) auf die Schicht des zweiten Isoliermaterials,
j) Photogravieren des Stapels von Schichten (114, 112, 110) des zweiten Leitungsmaterials, des zweiten Isoliermaterials und des Siliziums, um das Gate (G) der Transistoren so zu bilden, daß die Siliziumschicht (110) in Kontakt mit dem Source (S) und dem Drain (D) der Transistoren ist, und
k) Passivieren des Bauteils durch Auftragen einer Schicht eines dritten elektrisch isolierenden Materials (116).

2. Verfahren nach Anspruch 1, dadurch gekennzeichnet, daß das absorbierende Material (104) ein polymerisierbares, Opakfarbstoffe enthaltendes Harz ist.

3. Verfahren nach Anspruch 2, dadurch gekennzeichnet, daß das Bauteil zwischen den Schritten f und g getempert wird, um das Harz zu polymerisieren.

4. Verfahren nach Anspruch 2 oder 3, dadurch gekennzeichnet, daß das polymerisierbare Harz ein Polyimid ist.

5. Verfahren nach einem der Ansprüche 1 bis 4, dadurch gekennzeichnet, daß ein zwischen den Schritten e und f eine Schicht eines dritten leitenden Materials (108) aufgetragen wird, deren Dicke so bemessen ist, daß die Dicken des ersten und dritten Leitungsmaterials (106, 108) zusammen gleich der Dicke des Absorptionsmaterials (104) sind.

6. Verfahren nach einem der Ansprüche 1 bis 5, dadurch gekennzeichnet, daß die Negativmaske (105) auch dazu dient, eine der Platten (8) der herzustellenden Kondensatoren sowie der herzustellenden Spalten (2) zu maskieren, und daß diese Platten und Spaltan während des Schritts f ausgebildet werden.

7. Verfahren nach Anspruch 6, dadurch gekennzeichnet, daß auch die Zeilen (4) während des Schritts j hergestellt werden.

8. Anzeigeschirm mit Aktivmatrix, gebildet auf einem elektrisch isolierenden Substrat (100) und Punkte sowie Leitungszeilen (4) und -Spalten (6) zum Adressieren der Punkte umfassend, wobei jeder Punkt aus einem Kondensator (8) und einem Dünnschichttransistor (6) gebildet ist, dadurch gekennzeichnet, daß er eine optische Maske (102) aus einem elektrisch isolierenden Material umfaßt, die das sichtbare Licht absorbiert und unter dem Transistorkanal und direkt auf dem Substrat gelegen ist, ein Source (S) und Drain (D), die sich bezüglich der optischen Maske und in direktem Kontakt mit dem Substrat selbstanordnen, sowie ein Gate (114), welches über der optischen Maske liegt und von ihr getrennt ist durch eine Schicht von amorphem, hydrogenisiertem Silizium (110) und einem elektrisch isolierenden Material (112), welche übereinander gelegt sind, wobei das amorphe Silizium in Kontakt mit der Source und dem Drain ist.
